# EUROPEAN PATENT SPECIFICATION

(11) **EP 1 673 782 B1**
(45) Date of publication and mention of the grant of the patent: **30.12.2009**
(21) Application number: 04715740.9
(22) Date of filing: 27.02.2004
(51) Int. Cl.: G11C 11/14

(54) **MRAM ARRAY WITH SEGMENTED WORD AND BIT LINES**
MRAM-MATRIX MIT SEGMENTIERTEN WORT- UND BITLEITUNGEN
BATTERIE DE MEMOIRES MRAM COMPRENANT DES LIGNES SEGMENTEES DE MOTS ET DE BITS

(30) Priority: 23.09.2003 US 669481
(43) Date of publication of application: 28.06.2006
(73) Proprietor: Applied Spintronics Technology, Inc., Milpitas, CA 95035 (US)
(72) Inventor: TSANG, David, Cupertino, CA 95014 (US); MORRIS, Robert, Paul, Raleigh, NC 27606 (US)
(74) Representative: Brookes Batchellor LLP
(86) International application number: PCT/US2004/006002
(87) International publication number: WO 2005/041270

(56) References cited:
- US-A1- 2002 126 524
- US-A1- 2003 043 620
- US-A1- 2003 058 686
- US-A1- 2004 174 728
- US-B2- 6 678 187

## Description

### FIELD OF THE INVENTION

The present invention pertains to magnetic memories, and more particularly to a method and system for providing a magnetic random access memory (MRAM) that is preferably high density, nonvolatile and that has an architecture incorporating magnetic write lines.

### BACKGROUND OF THE INVENTION

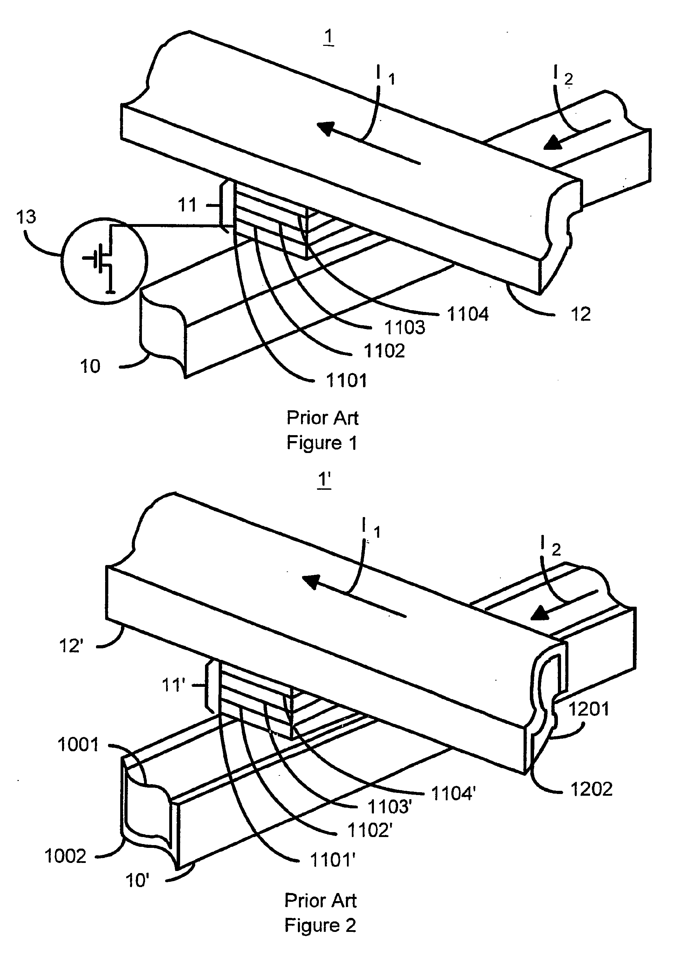

Recently, a renewed interest in thin-film magnetic random access memories (MRAM) has been sparked by the potential application of MRAM to both nonvolatile and volatile memories. Figure 1 depicts a portion of a conventional MRAM 1. The conventional MRAM includes conventional orthogonal conductor lines 10 and 12, conventional magnetic storage cell 11 and conventional transistor 13. The conventional MRAM 1 utilizes a conventional magnetic tunneling junction (MTJ) stack 11 as a memory cell. Use of a conventional MTJ stack 11 makes it possible to design an MRAM cell with high integration density, high speed, low read power, and soft error rate (SER) immunity The conductive lines 10 and 12 are used for writing data into the magnetic storage device 11. The MTJ stack 11 is located on the intersection of and between 10 and 12. Conventional conductive line 10 and line 12 are referred to as the conventional word line 10 and the conventional bit line 12, respectively. The names, however, are interchangeable. Other names, such as row line, column line, digit line, and data line, may also be used.

The conventional MTJ 11 stack primarily includes the free layer 1104 with the changeable magnetic vector (not explicitly shown), the pinned layer 1102 with the fixed magnetic vector (not explicitly shown), and the insulator 1103 in between the two magnetic layers 1104 and 1102. The insulator 1103 typically has a thickness that is low enough to allow tunneling of charge carriers between the magnetic layers 1102 and 1104. Layer 1101 is usually a composite of seed layers and an anti-ferromagnetic layer that is strongly coupled to the pinned magnetic layer.

Data is stored in the conventional MTJ stack 11 by applying a magnetic field to the conventional MTJ stack 11. The applied magnetic field has a direction chosen to move the changeable magnetic vector of the free layer 1104 to a selected orientation. During writing, the electrical current I₁ flowing in the conventional bit line 12 and I₂ flowing in the conventional word line 10 yield two magnetic fields on the free layer 1104. In response to the magnetic fields generated by the currents I₁ and I₂, the magnetic vector in free layer 1104 is oriented in a particular, stable direction. This direction depends on the direction and amplitude of I₁ and I₂ and the properties and shape of the free layer 1104. Generally, writing a zero (0) requires the direction of either I₁ or I₂ to be different than when writing a one (1). Typically, the aligned orientation can be designated a logic 1 or 0, while the misaligned orientation is the opposite, i.e., a logic 0 or 1, respectively.

Stored data is read or sensed by passing a current through the conventional MTJ cell from one magnetic layer to the other. During reading, the conventional transistor 13 is turned on and a small tunneling current flows through the conventional MTJ cell. The amount of the current flowing through the conventional MTJ cell 11 or the voltage drop across the conventional MTJ cell 11 is measured to determine the state of the memory cell. In some designs, the conventional transistor 13 is replaced by a diode, or completely omitted, with the conventional MTJ cell 11 in direct contact with the conventional word line 10.

Although the above conventional MTJ cell 11 can be written using the conventional word line 10 and conventional bit line 12, one of ordinary skill in the art will readily recognize that the amplitude of I₁ or I₂ is in the order of several milli-Amperes for most designs. Therefore, one of ordinary skill in the art will also recognize that a smaller writing current is desired for many memory applications.

Figure 2 depicts a portion of a conventional magnetic memory 1' that has a lower writing current. Similar systems are described in U.S. Patent No. 5,659,499, U.S. Patent No. 5,940,319, U.S. Patent No. 6,211,090, U.S. Patent No. 6,153,443, and U.S. Patent Application Publication No. 2002/0127743. The conventional systems and conventional methods for fabricating the conventional systems disclosed in these references encapsulate bit lines and word lines with soft magnetic cladding layer on the three surfaces not facing MTJ cell 11'. Many of the portions of the conventional memory depicted in Figure 2 are analogous to those depicted in Figure 1 and are thus labeled similarly. The system depicted in Figure 2 includes the conventional MTJ cell 11', conventional word line 10' and bit line 12'. The conventional word line 10' is composed of two parts: a copper core 1001 and a soft magnetic cladding layer 1002. Similarly, the conventional bit line 12' is composed of two parts: a copper core 1201 and a soft magnetic cladding layer 1202.

Relative to the design in Figure 1, the soft magnetic cladding layers 1002 and 1202 can concentrate the magnetic flux associated with I₁ and I₂ onto the MTJ cell 11' and reduce the magnetic field on the surfaces which are not facing the MTJ cell 11'. Thus, the sot magnetic cladding layers 1002 and 1202 concentrate the flux on the MTJ that makes up the MTJ cell 11', making the free layer 1104 easier to program.

Although this approach works well theoretically, one of ordinary skill in the art will readily recognize that the magnetic properties of the portions of the soft cladding layers 1002 and 1202 on the vertical sidewalls of the conventional lines 10' and 12', respectively, are hard to control. One of ordinary skill in the art will also recognize that the process of making the conventional word line 10' and the conventional bit line 12' is complicated. Formation of the conventional word line 10' and conventional bit line 12' including the cladding layers 1002 and 1202, respectively, requires approximately nine thin film deposition steps, five photolithography steps, six etching steps, and one chemical mechanical polishing (CMP) step. Furthermore, none of the processes can be shared with other CMOS processes. Some of the processes, such as the CMP process and a few thin-film deposition and etching processes, need to be tightly controlled in order to achieve the designed performance. Because the wafer surface on which the devices are fabricated is not flat and the portion to be removed is deep in the trenches, the write lines 10' and 12' need to be laid out fairly sparsely to accommodate the photolithography process. As a consequence, the density and capacity of memory devices on a chip will be sacrificed if soft magnetic cladding layer 1202 and 1002 is used for the lines 10' and 12'. This complicated fabrication methods pose significant challenge to scaling to higher densities. Accordingly it is highly desirable to provide an MRAM architecture which is scalable, easy to fabricate, and offers high writing efficiency.

Other aspects of the conventional write lines 10, 10', 12, and 12' of the conventional designs depicted in both Figure 1 and Figure 2 limit scalability. In these conventional designs, the conventional write lines 10, 10', 12, and 12'are mostly made of either aluminum or copper. The current density limits for aluminum and copper are in the order of 1x10⁶ A/cm² or less. As the line width decreases to increase the memory density, the electromigration current density limit poses severe challenges for scaling.

Other conventional systems attempt to propose different solutions, each of which has its drawbacks. As an example, U.S. Patent Application Publication No. 2002/0080643 proposed that, after a write operation, a reverse current is applied to the write lines to prevent electromigration. But such conventional methods compromise performance by reducing the speed of the memory and add complexities. Thus, it is also highly desirable to have write line made of materials with high reliability in electromigration, which will allows for easy scalability to high density memory arrays.

Conventional thin bit lines, which might be used for smaller or more efficient memories have shortcomings. Thinner conventional bit lines have higher resistances. This adversely affects the performance of the overall memory array. However, there are many conventional methods of overcoming this issue. One common practice is to break up the long bit lines in the memory array into global bit lines that are made of thick metals, and connect the global bit lines into local bit lines that are made of thinner metals, and thus have a higher resistance. Examples of such design are taught by U.S. Patent No. 6,335,890 and U.S. Patent Application Publication No. 2002/0034117. However, the other problems described above, such as the electromigration are still not overcome.

Similarly, other conventional systems break write lines into segments, each of which is coupled, through a selection transistor, to a global write line having a much lower resistance. For example, U. S. Patent No. 6,335,890 and U.S. Patent Application Publication No. 2002/0176272 describe systems which break conventional write lines into segments. During writing, only one segment of the conventional write line conducts current.

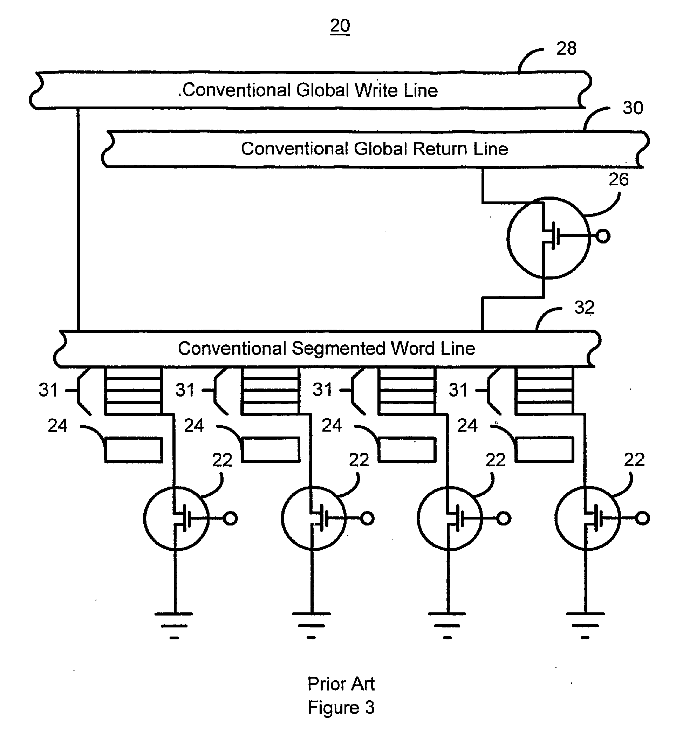

Figure 3 depicts such a conventional design 20 incorporating a conventional segmented write line. The conventional design 20 includes conventional MTJs 31 serving as MRAM cells, a conventional segmented magnetic write line 32, conventional global write and return lines 28 and 30, respectively, conventional selection transistors 26, conventional digit lines 24, and conventional bit selection transistors 22. The conventional segmented write line 32 is connected to the conventional global write line 28 and to the conventional global write return line 30, through the conventional section selection transistor 26. Other segments (not shown) would be connected to the conventional global write line 28 and conventional global write return line 30 in a similar manner. For illustration, the section of the conventional segmented write line 32 is connected to four conventional MTJs 31. In a conventional configuration, each conventional MTJ 31 is then connected to a ground line through a conventional bit selection transistor 22. The conventional digit line 24 runs orthogonal to the conventional write line 32 at each conventional MTJ 31.

During writing, the conventional transistor 26 is turned on to allow a write current to flow from the conventional global write line 28, through the segment of the conventional segmented write line 32, to the conventional to global write return line 30. The magnetic field generated by the write current in the conventional segmented write line 32 simultaneously disturbs the magnetic vectors of the free layers of the four conventional MTJs 31 contained in the section. Depending on the magnitude and polarities of currents flowing in the conventional digit lines 24, digital data are written into the conventional MTJs 31. In this way four MRAM cells can be written at the same time.

Although four MRAM cells can be written in parallel, one of ordinary skill in the art will readily recognize that during reading only one of the four bit selection transistors 22 can be turned on. When one of the four bit selection transistors 22 is turned on, the voltage on the conventional global write line 28 (as connected to the conventional segmented write line 32) can be measured to determine the logical state of the selected MTJ 31. Thus, although data in the four cells of the section can be written in parallel, the data stored in the four cells are read in series. One of ordinary skill in the art will readily recognize, therefore, that reading of data stored in the MTJs 31 may be less efficient than desired. Furthermore, other problems described above, such as the electromigration are still not overcome.

Accordingly, what is needed is a system and method for providing a scalable, efficient, low current magnetic memory that improves ease of manufacturing and reliability against electromigration. It would also be desirable to provide an architecture which can support a simpler driver design, and can be read more efficiently. Moreover, it is desirable to arrange the global write lines such that there is minimal magnetic interference induced by the currents flowing in the global write lines on MRAM cells. It would also be desirable to achieve a system and method for providing a high-density nonvolatile MRAM capable of having greater margin in writing as well as efficient reading operations. The present invention addresses such a need.

US 2002/126524 A1 discloses a semiconductor memory apparatus using tunnel magnetic resistance elements and comprising the features in the pre-amble to claim 1.

### SUMMARY OF THE INVENTION

The present invention provides a magnetic random access memory array comprising: a plurality of magnetic storage cells; a plurality of global word lines; a plurality of word line segments, each of the plurality of word line segments being coupled with at least one of the plurality of global word lines such that the plurality of word line segments is selectable, each of the plurality of word line segments being coupled to a first portion of the plurality of magnetic storage cells; a plurality of global bit lines; a plurality of bit line segments, each of the plurality of bit line segments being coupled with at least one of the plurality of global bit lines such the plurality of bit line segments is selectable, each of the plurality of bit line segments residing in proximity being magnetostatically coupled to a second portion of the plurality of magnetic storage cells to write to the second portion of the plurality of magnetic storage cells; and a plurality of selection devices, the plurality of bit line segments and the plurality of word line segments being coupled with and selectable using the plurality of selection devices, wherein: the magnetic random access memory array further comprises at least one global word line return coupled with at least one of the plurality of global word lines through at least one of the plurality of selection devices; and the magnetic random access memory array further comprises at least one global bit line return coupled with at least one of the plurality of global bit lines through at least one of the plurality of selection devices.

Accordingly, the present invention provides a magnetic memory having improved writing margin and reading efficiency.

The present invention further provides a method for utilizing a magnetic random access memory array having a plurality of magnetic storage cells and a plurality of global word lines, the method comprising: (a) in a write mode, driving a word line current through at least one of the plurality of global word lines; b) in the write mode, driving at least a portion of the word line current from the at least one of the plurality of global word lines through at least one of a plurality of word line segments, each of the plurality of word line segments being coupled with a portion of the plurality of global word lines such that the plurality of word line segments is separately selectable, each of the plurality of word line segments being coupled to a first portion of the plurality of magnetic storage cells; (c) in the write mode, driving a bit line current through at least one of a plurality of global bit lines; and (d) in the write mode, providing at least a portion of the bit line current through a portion of a plurality of bit line segments, each of the plurality of bit line segments being coupled with at least one of the plurality of global bit lines such that the plurality of bit line segments is selectable, each of the plurality of segments being magnetostatically coupled to a second portion of the plurality of magnetic storage cells to write to the second portion of the plurality of magnetic storage cells; wherein the plurality of bit line segments and the plurality of word line segments are coupled with and selectable using the plurality of selection devices, wherein either: the global word line driving step (a) further comprises (a1) utilizing at least one global word line return coupled with at least one of the plurality of global word lines through at least one selection device to return the word line current; or the global bit line driving step (c) further comprises (c1) utilizing at least one global bit line return coupled with at least one of the plurality of global bit lines through at least one selection device to return the bit line current.

### BRIEF DESCRIPTION OF THE DRAWINGS

Figure 1 is a three-dimensional view of a conventional MRAM cell containing a conventional MTJ, located at the intersection of a conventional bit line and a conventional word line.
Figure 2 is a three-dimensional view of another conventional MTJ in a conventional MRAM cell with a conventional magnetic write line.
Figure 3 is a diagram depicting a conventional configuration of conventional segmented magnetic write lines.
Figure 4A is a diagram depicting one example of a portion of an MRAM utilizing magnetic write lines.
Figure 4B is a diagram depicting another example of a portion of an MRAM utilizing magnetic write lines.
Figure 5 is a schematic diagram illustrating a first embodiment of a portion of an MRAM in accordance with the present invention.
Figure 6 is a schematic diagram illustrating a second embodiment of a portion of an MRAM in accordance with the present invention.
Figure 7 is a schematic diagram illustrating a third embodiment of a portion of an MRAM in accordance with the present invention.
Figure 8 is a schematic diagram illustrating a fourth embodiment of a portion of an MRAM in accordance with the present invention.
Figure 9 is a schematic diagram illustrating a fifth embodiment of a portion of an MRAM in accordance with the present invention.

### DETAILED DESCRIPTION OF THE INVENTION

The present invention relates to an improvement in magnetic memories. The following description is presented to enable one of ordinary skill in the art to make and use the invention and is provided in the context of a patent application and its requirements.

Various modifications to the preferred embodiment will be readily apparent to those skilled in the art and the generic principles herein may be applied to other embodiments. Thus, the present invention is not intended to be limited to the embodiment shown, but is to be accorded the scope consistent with the claims.

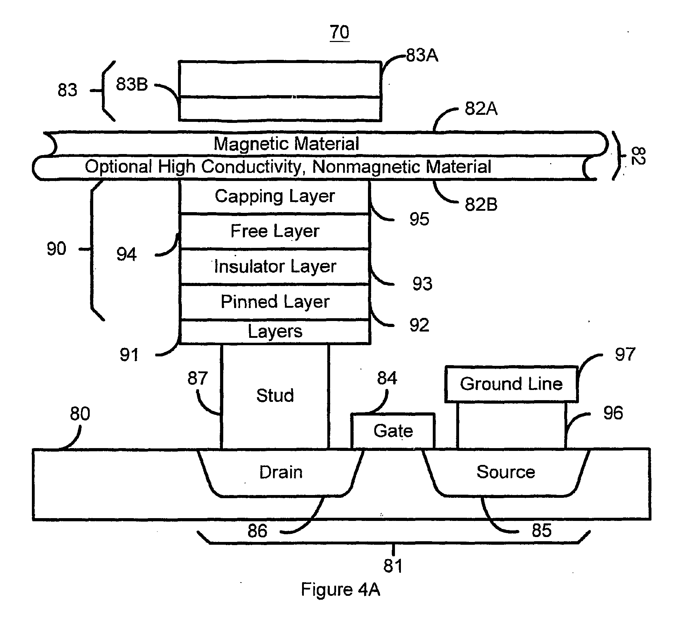

U.S. patent No. 6,909,630 entitled "MRAM MEMORIES UTILIZING MAGNETIC WRITE LINES" describes a MRAM architecture that addresses many of the issues encountered in conventional MRAM devices. Figure 4A depicts one embodiment of a portion of an MRAM 70 including the basic structure described in the above-identified patent

The MRAM 70 depicted in Figure 4A includes a magnetic element 90, which is preferably a MTJ stack 90, a selection device 81 formed in a substrate 80, a magnetic write line 82 that is preferably a bit line, a word line 83, a conductive stud 87, connecting stud 96 and ground line 97. The selection device 81 is preferably a FET transistor including gate 84, source 85 and drain 86. The MTJ stack includes the pinned layer 92 having a fixed magnetic vector (not shown), a tunneling layer 93, a free layer 94 having a changeable magnetic vector (not shown), and a conductive capping layer 95. The conductive capping layer 95 is preferably a nonmagnetic spacer layer 95. The MTJ stack also includes layers 91 that includes seed and, preferably, antiferromagnetic layers.

The magnetic write line 82 includes soft magnetic materials and is separated from the free layer 94 of the MTJ stack 90 by the non-magnetic spacer layer 95. The magnetic write line 82 is preferably substantially or completely composed of a soft magnetic material. In addition, at least a core, as opposed to a cladding layer, includes the soft magnetic layer. In the example shown, the magnetic write line 82 includes a soft magnetic portion 82A and a higher conductivity nonmagnetic portion 82B, for example made of copper. However, in an alternate example, the entire magnetic write line 82 is composed of a soft magnetic material. In addition, the write line 83 may be magnetic. In a preferred example, as shown in Figure 4A, the write line 82 includes a soft magnetic portion 82A and a high conductivity nonmagnetic portion 82B. The non-magnetic spacer layer 95 is preferably thin, for example less than or equal to three hundred Angstroms in thickness. Due to the small spacing between the magnetic write line 82 and the free layer 94, the magnetic vector of free layer 94 is strongly coupled magnetostatically to the magnetic vector of the magnetic write line 82. Such a magnetostatic coupling promotes rotation amplitude for the free layer magnetic vector. Hence, using the method and system described in the above-identified patent, a lower current can be used because of the strong magnetic coupling between the soft magnetic write line 82 and the MTJ 90. Furthermore, because of the excellent electromigration reliability of magnetic alloys, the magnetic write lines can be made thin for ease of fabrication and better packing density.

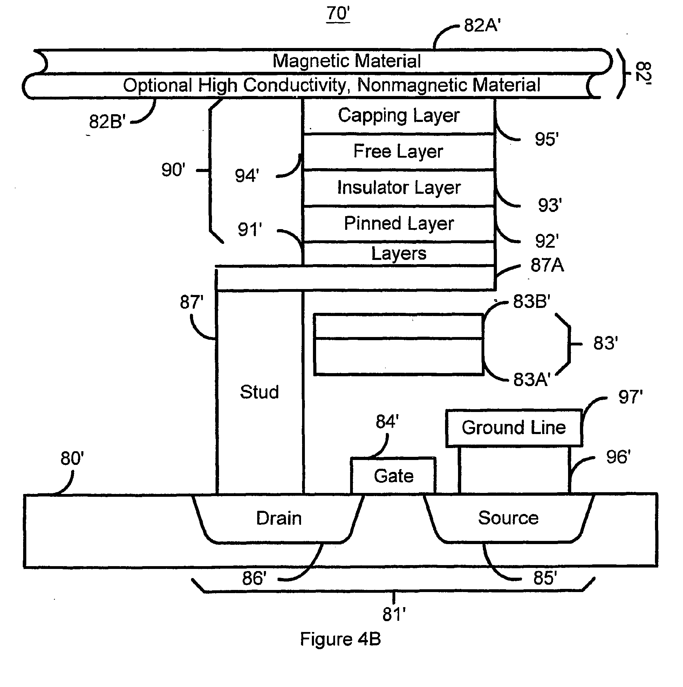

Figure 4B depicts another example of the MRAM 70' including the magnetic write line 83'. Many components of the MRAM 70' are analogous to those in the MRAM 70 depicted in Figure 4A. Consequently, these components are labeled similarly. The magnetic write line 82' can include only the soft magnetic material 82A' or, as depicted, may include both the soft magnetic material 82A' and the high conductivity nonmagnetic material 82B'. The word line 83' is, however, placed beneath the magnetic element 90' and is connected to the MTJ stack 90 through a conductive layer 87A. In addition, the write line 83' may be magnetic.

Although the method and system described in the above-identified patent function well for their intended purpose, one of ordinary skill in the art will readily recognize that the magnetic write lines often have a relatively high resistance. Due to the combination of the small thickness and the use of the higher resistivity of magnetic alloys, the line resistance of magnetic write lines may be much larger than conventional write lines of primarily copper or aluminum. This high resistivity can create difficulties for write driver circuit designs.

U.S. Patent No.6,870 759, entitled "MRAM ARRAY WITH SEGMENTED MAGNETIC WRITE LlNES", filed on August 21, 2003, describes an architecture in which magnetic word lines may be segmented. In particular, word lines, such as the lines 83 and 83' may be divided into segments. Each segment is coupled with the global word line(s) such that each segment is separately selectable. Each segment is also coupled to a portion of the magnetic storage cells. The segments of the magnetic word lines may include soft magnetic materials and are coupled to each magnetic storage cell through a thin, nonmagnetic layer. In some example, the magnetic word lines include a high conductivity layer as well as a soft magnetic layer. Consequently, writing efficiency is improved. The global word lines preferably have a low resistance due to the use of a high conductivity material in the global word lines. Thus, the drawbacks due to high resistivity materials can be mitigated.

Although the method and system described in the above-identified patent function well for their intended purpose, one of ordinary skill in the art will readily recognize that the magnetic bit lines often have a relatively high resistance. The architecture described in the above-identified patent may not, therefore, have the desired performance due to the high resistance of the magnetic bit lines.

The present invention provides a method and system for providing and using a magnetic random access memory (MRAM) array. The method and system comprise providing a plurality of magnetic storage cells, a plurality of global word lines and global word line segments, a plurality of global bit lines and bit line segments, and a plurality of selection devices. Each of the word line segments is coupled with at least one of the global word lines such that the word line segments are selectable. Each of the word line segments is magnetically coupled to the free layer of the magnetic storage cells. Each of the bit line segments is coupled with at least one of the global bit lines such the bit line segments are selectable. In a preferred embodiment, each of the bit line segments are both electrically and magnetically coupled to and is used to write to of magnetic storage cells. The bit line segments and the word line segments are coupled with and selectable using the plurality of selection devices.

The present invention will be described in terms of particular types of magnetic memory cells, particular materials and a particular configuration of elements. However, one of ordinary skill in the art will readily recognize that this method and system will operate effectively for other magnetic memory cells, and other materials and configurations non inconsistent with the present invention. '

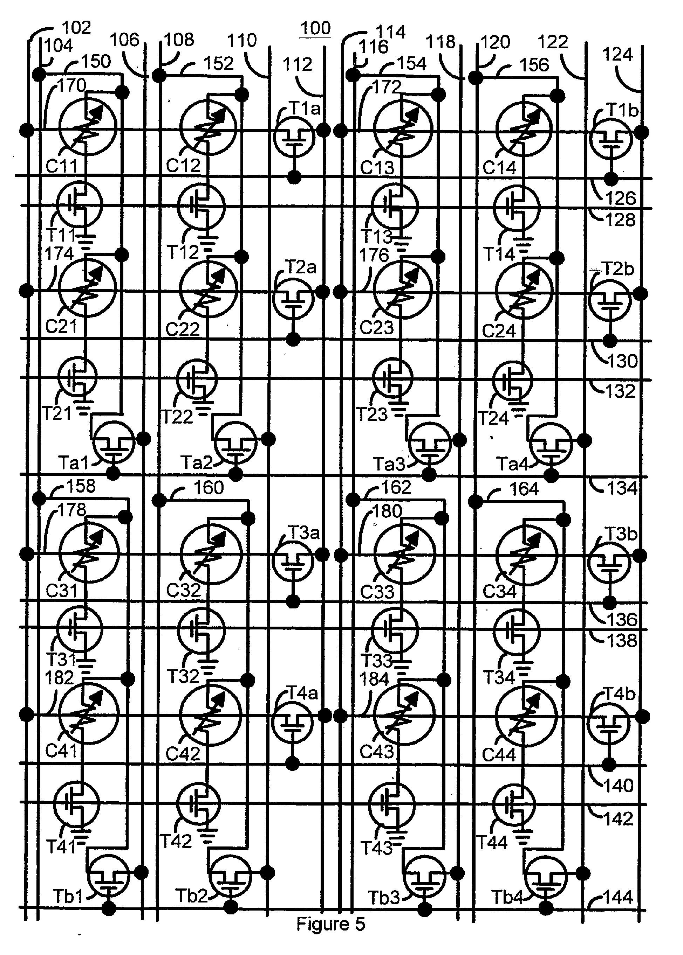

To more particularly illustrate the method and system in accordance with the present invention, refer now to Figure 5, depicting one embodiment of an MRAM array 100 in accordance with the present invention. The MRAM array 100 includes magnetic storage cells C11, C12, C13, C14, C21, C22, C23, C24, C31, C32, C33, C34, C41, C42, C43, and C44. The magnetic storage cells C11, C12, C13, C14, C21, C22, C23, C24, C31, C32, C33, C34, C41, C42, C43, and C44 are preferably MTJs, as depicted in Figures 4A and 4B. However, in an alternate embodiment, other types of cells, such as GMR or AMR cells, could be used. Each magnetic storage cell C11, C12, C13, C14, C21, C22, C23, C24, C31, C32, C33, C34, C41, C42, C43, and C44 is coupled to ground via read selection devices that are preferably transistors T11, T12, T13, T14, T21, T22, T23, T24, T31, T32, T33, T34, T41, T42, T43, and T44. The MRAM array 100 includes global word lines 102 and 114 coupled with global word line returns 112 and 124, respectively. In an alternate embodiment, the selection devices could be diodes. The MRAM array also includes global bit lines 104, 108,116 and 120 that may be coupled with global bit line returns 106, 110, 118, and 122, respectively. In addition, the MRAM array 100 includes write word lines 126, 130, 136, and 140 as well as read word lines 128, 132, 138, and 142. The MRAM array 100 also includes word partition lines 134 and 144.

The word lines of the MRAM 100 are segmented, preferably in the manner analogous to that disclosed in the above-identified co-pending patent application. Consequently, the MRAM 100 includes word line segments 170, 172, 174, 176, 178, 180, 182, and 184. The word line segments 170, 174, 178, and 182 are coupled to global word line 102 at one end. The word line segments 170, 174, 178, and 182 can also be coupled with global word return line 112 through selection devices that are preferably selection transistors T1a, T2a, T3a, and T4a, respectively. In an alternate embodiment, the selection devices could be diodes. Similarly, the word line segments 172, 176, 180, and 184 are coupled to global word line 114 at one end. The word line segments 172, 176, 180, and 184 can also be coupled with global word return line 124 through selection devices that are preferably selection transistors T1b, T2b, T3b, and T4b, respectively.

Each word line segment 170, 172, 174, 176, 178, 180, 182, and 184 is coupled to two magnetic storage cells. In the embodiment shown, the word line segment 170 passes by magnetic storage cells C11 and C12. The word line segment 172 passes by magnetic storage cells C13 and C14. The word line segment 174 passes by magnetic storage cells C21 and C22. The word line segment 176 passes by magnetic storage cells C23 and C24. The word line segment 178 passes by magnetic storage cells C31 and C32. The word line segment 180 passes by magnetic storage cells C33 and C34. The word line segment 182 passes by magnetic storage cells C41 and C42. The word line segment 182 passes by magnetic storage cells C43 and C44:

The bit lines of the MRAM 100 are also segmented. Consequently, the MRAM 100 includes bit line segments 150, 152, 154, 156, 158, 160, 162, and 164. The word line segments 170, 172, 174, 176, 178, 180, 182, and 184 and/or the bit line segments 150, 152, 154, 156, 158, 160, 162, and 164 may be magnetic as described in the above-identified co-pending application. The bit line segments 150 and 158 are coupled to global bit line 104 at one end. The bit line segments 150 and 158 can also be coupled with global return line 106 through selection devices that are preferably selection transistors Ta1 and Tb1, respectively. Similarly, the bit line segments 152 and 160 are coupled to global bit line 108 at one end. The bit line segments 152 and 160 can also be coupled with global return line 110 through selection devices that are preferably selection transistors Ta2 and Tb2, respectively. The bit line segments 154 and 162 are coupled to global bit line 116 at one end. The bit line segments 154 and 162 can also be coupled with global return line 118 through selection devices that are preferably selection transistors Ta3 and Tb3, respectively. The bit line segments 156 and 164 are coupled to global bit line 120 at one end. The bit line segments 156 and 164 can also be coupled with global return line 122 through selection devices that are preferably selection transistors Ta4 and Tb4, respectively.

The bit line segments 150, 152, 154, 156, 158, 160, 162, and 164 preferably include a conductive soft magnetic material. In one embodiment, one or more of the bit line segments 150, 152, 154, 156, 158, 160, 162, and 164 are completely composed of a conductive soft magnetic material. In an alternate embodiment, one or more of the bit line segments 150, 152, 154, 156, 158, 160, 162, and 164 include a soft magnetic material formed on a high conductivity material, such as copper. Thus, the bit line segments 150, 152, 154, 156, 158, 160, 162, and 164 may be analogous to the bit lines 82 and 82 of Figures 4A and 4B. Referring back to Figure 5, the soft magnetic material(s) used in the bit line segments 150, 152, 154, 156, 158, 150, 162, and 164 may be a single material such as nickel, cobalt, iron or an alloy thereof, or may be a composite including more than one layer. The high conductivity metal is preferably copper, aluminum, gold, an alloy thereof or a composite layer. In addition, other layers such as barrier layers (not shown) and/or adhesion layers (not shown) could be provided. Moreover, to improve efficiency, the thickness of the bit line segments 150, 152, 154, 156, 158, 160, 162, and 164 is preferably much smaller than the width. For example, the thickness of the bit line segments 150, 152, 154, 156, 158, 160, 162, and 164 is preferably approximately one fourth of the width.

Each bit line segment 150, 152, 154, 156, 158, 160, 162, and 164 is coupled to two magnetic storage cells. In the embodiment shown, the bit line segment 150 is coupled to magnetic storage cells C11 and C21. The bit line segment 152 is coupled to magnetic storage cells C12 and C22. The bit line segment 154 is coupled to magnetic storage cells C13 and C23. The bit line segment 156 is coupled to magnetic storage cells C14 and C24. The bit line segment 158 is coupled to magnetic storage cells C31 and C41. The bit line segment 160 is coupled to magnetic storage cells C32 and C42. The bit line segment 162 is coupled to magnetic storage cells C33 and C43. The bit line segment 164 is coupled to magnetic storage cells C34 and C44. Thus, both the bit lines and the word lines of the MRAM 100 are segmented.

The magnetic cells C11, C12, C13, C14, C21, C22, C23, C24, C31, C32, C33, C34, C41, C42, C43, and C44 are written to by passing currents through various word lines and bit lines, depending upon to which cells data are being written. For example, suppose data are written to cells C33 and C34. Current must flow through the appropriate word lines and bit lines. To write to cells C33 and C34, the global word line 114 is coupled with a word line current source (not shown), while the global word line return 124 is coupled to a word line current sink (not shown). A voltage is provided on write word line 136, which enables the selection transistor T3b. Consequently, current flows through the word line segment 180 of the global word line 114, in proximity to the cells C33 and C34, and returns via global word line return 124. Cells C33 and C34 are written, preferably simultaneously, using different bit line segments 162 and 164, respectively. The bit line current and polarity are supplied for C33 using global bit line 116 and its corresponding global bit line return 118. Depending upon the data to be written, the global bit line 116 is connected to one of the bit line current source (not shown) or the bit line current sink (not shown), while the global bit line return 118 is connected to the other of the bit line current sink or bit line current source, respectively. To enable the appropriate bit line segment 162 for C33, an enable voltage is provided to the partition line 144, which enables transistor Tb3 (as well as transistor Tb4). The appropriate currents for writing to the cell C33 thus flow through word line segment 180 and bit line segment 162. To write to the cell C34, the bit line current and polarity are supplied for C34 using global bit line 120 and its corresponding global bit line return 122. Depending upon the data to be written, the global bit line 120 is connected to one of the bit line current source (not shown) or the bit line current sink (not shown), while the global bit line return 122 is connected to the other of the bit line current sink or bit line current source, respectively. To enable the appropriate bit line segment 164 for C33, the enable voltage provided to the partition line 144, which enables transistor Tb3, also enables the transistor Tb4. The appropriate currents for writing to the cell C34 thus flow through word line segment 180 and bit line segment 164. The other cells C11, C12, C13, C14, C21, C22, C23, C24, C31, C32, C41, C42, C43, and C44 are written to in an analogous manner.

To read the data stored in cells C33 and C34, an enable signal is provided to the appropriate read word line, 138. Consequently, the transistors T33 and T34 are enabled. Consequently, the cells C33 3 and C34 are coupled to ground. A read current is provided through global bit lines 116 and 120 for cells C33 and C34, respectively. Consequently, the current flows through bit line segments 162 and 164 and to ground through cells C33 and C34, respectively. The voltage of the global bit lines 116 and 120 can be measured to determine the states of the cells C33 and C34, respectively. Thus, the data in cells C33 and C34 can be read.

Using the MRAM 100, therefore, thinner bit line segments 150, 152, 154, 156, 158, 160, 162, and 164 and thinner word line segments 170,172,174, 176, 178, 180, 182, and 184 can be provided. As a result, a more efficient writing architecture can be achieved. Moreover, the global bit lines 104 and 106, 108 and 110, 116 and 118, and 120 and 122, as well as the global word lines 102 and 112 and 114 and 124 can be made thicker, as well as using higher conductivity materials. Consequently, the benefits of thinner word and bit lines can be achieved without sacrificing performance due to high resistivity of thinner lines. In addition, in the architecture depicted in Figure 5, the global word lines 102 and 114, the global word line returns 112 and 124 are parallel to the global bit lines 104, 108, 116 and 118 as well as to the global bit line returns 106, 110, 118, and 122. Consequently, these structures 102, 104, 106, 108, 110, 116, 118, 120, 122, and 124 may be fabricated on the same layer, further reducing the cost of fabricating the MRAM 100. Furthermore, if the bit line segments 150, 152, 154, 156, 158, 160, 162, and 164 and word line segments 170, 172, 174, 176, 178, 180, 182, and 184 are composed all or in part of magnetic materials, for example as shown in Figures 4A and 4B, the performance can be achieved without complicating fabrication of the MRAM 100. As a result, performance of the MRAM 100 can be enhanced while simplifying processing and reducing cost.

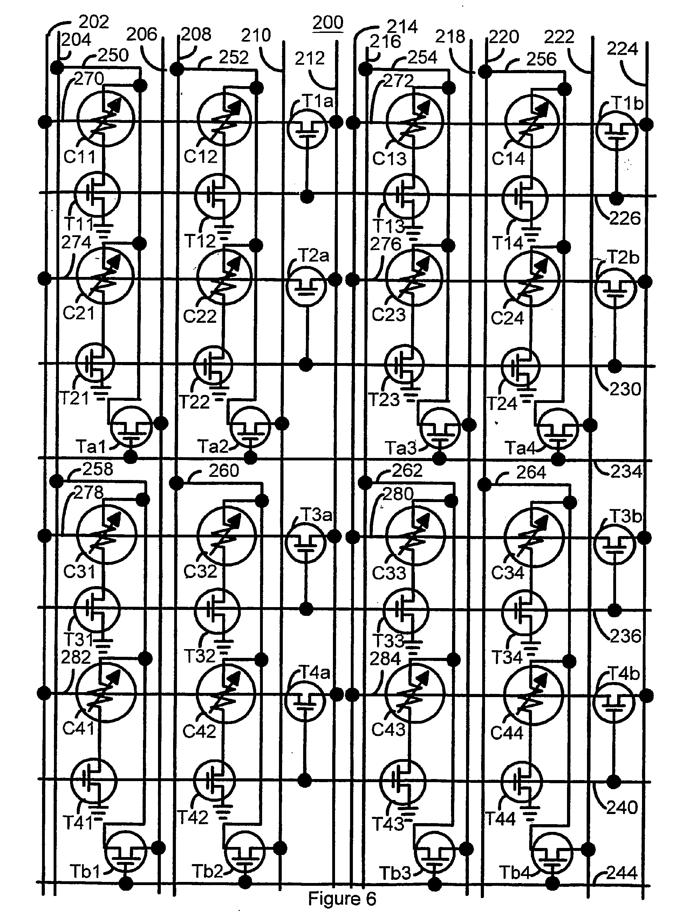

Figure 6 is a schematic diagram illustrating a second embodiment of a portion of an MRAM 200 in accordance with the present invention. Elements of the MRAM 200 are analogous to those in the MRAM 100. Consequently, such components are labeled similarly. For example, the MRAM 200 includes cells C11, C12, C13, C14, C21, C22, C23, C24, C31, C32, C33, C34, C41, C42, C43, and C44. Similarly, the MRAM 200 includes global word lines 202 and 214 (analogous to global word lines 102 and 114 of Figure 5) and global word line returns 212 and 224 (analogous to global word line returns 112 and 124 of Figure 5). However, the MRAM 200 has combined at least a portion of the read word lines and the write word lines of Figure 5 into a single line. Referring to Figures 5 and 6, the MRAM 200 thus includes read word lines 226, 230, 236, and 240 as well as partition lines 234, and 244.

The MRAM 200 is read in the same way as the MRAM 100, using the read word line 226, 230, 236, or 240 to enable the appropriate transistors and coupled the appropriate cells to ground. For example, in reading cells C33 and C34, the read word line 236 enables transistors T33 and T34 (as well as transistor T3b) to couple the cells to ground. A current passed through the bit lines 216 and 220 is thus transmitted through bit line segments 262 and 264 and through the cells C33 and C34, respectively, to ground.

The MRAM 200 can be written to in an analogous manner to the MRAM 100. Thus, current flows through the appropriate word and bit line segments during writing. However, a minimum voltage drop across the any MTJ stacks in the cells C11, C12, C13, C14, C21, C22, C23, C24, C31, C32, C33, C34, C41, C42, C43, and C44 is preferably ensured during writing. Thus, if the cells C11, C12, C13, C14, C21, C22, C23, C24, C31, C32, C33, C34, C41, C42, C43, and C44 use an MTJ as a storage element, the minimum voltage ensures that the insulating layer, such as the layer 93 or 93', does not undergo breakdown. In general, it is believed that a voltage on the global bit lines 104, 108, 116, and 120 should be less than one volt during writing. In the alternative or in addition to reducing the voltage on the global bit lines 104, 108, 116, and 120, the cells C11, C12, C13, C14, C21, C22, C23, C24, C31, C32, C33, C34, C41, C42, C43, and C44 can be connected to a voltage source through transistors T11, T12, T13, T14, T21, T22, T23, T24, T31, T32, T33, T34, T41, T42, T43, and T44 (instead of ground) during writing. During writing, the voltage source would provide a voltage sufficient to ensure a minimum voltage drop across any stacks in the cells C11, C12, C13, C14, C21, C22, C23, C24, C31, C32, C33, C34, C41, C42, C43, and C44.

Thus, the MRAM 200 enjoys essentially the same benefits as the MRAM 100 depicted in Figure 5. For example, a more efficient architecture can be achieved while simplifying processing and reducing the cost of the MRAM 200. Data can be read and written in parallel to cells on the same word line segment and/or bit line segment. Furthermore, some read and write word lines have been merged to lines 226, 230, 236, and 240. Consequently, the MRAM 200 is even simpler to fabricate.

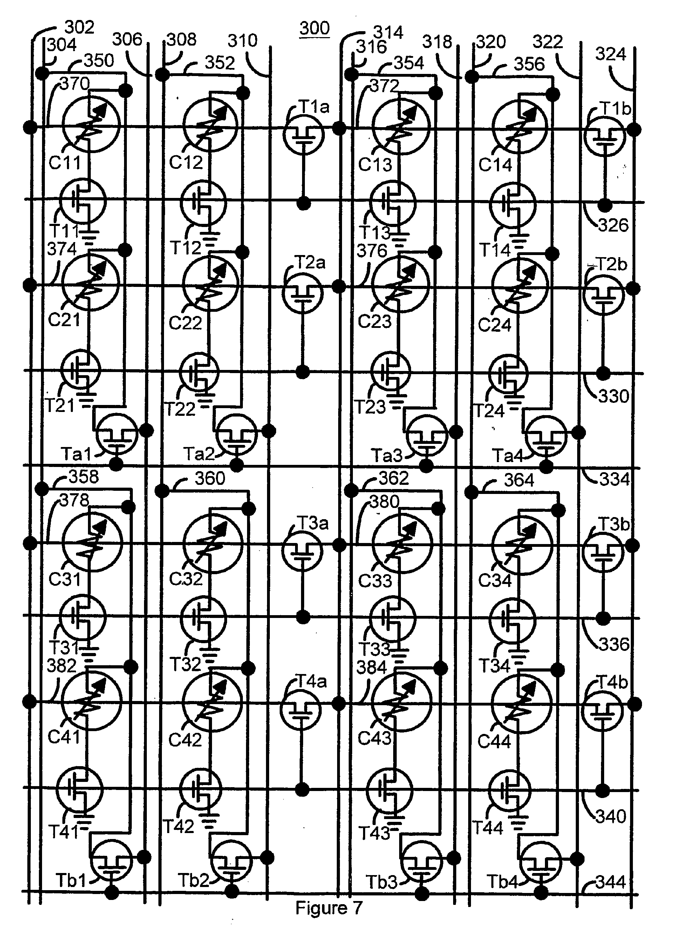

Figure 7 is a schematic diagram illustrating a third embodiment of a portion of an MRAM 300 in accordance with the present invention. Elements of the MRAM 300 are analogous to those in the MRAM 200. Consequently, such components are labeled similarly. For example, the MRAM 300 includes cells C11, C12, C13, C14, C21, C22, C23, C24, C31, C32, C33, C34, C41, C42, C43, and C44. Similarly, the MRAM 300 includes global bit lines 304, 308, 316, and 320 (analogous to global bit lines 204, 208, 216, and 220 Figure 6). However, the MRAM 300 has combined at least a portion of the word return lines and global word lines of Figure 6. Referring to Figures 6 and 7, the MRAM 300 thus includes global bit lines 304, 308, 316, and 320, global bit line returns 306, 310, 318 and 322, but includes only global write lines 302 and 314 and global word line return 324.

The MRAM 300 is read in the same way as the MRAM 100, using the read word line 326, 330, 336, or 340 to enable the appropriate transistors and coupled the appropriate cells to ground. For example, in reading cells C11 and C12, the read word line 326 enables transistors T11 and T12 (as well as transistor T1a) to couple the cells C11 and C12 to ground. A current passed through the global bit lines 304 and 308 is thus transmitted through bit line segments 350 and 352 and through the cells C33 and C34, respectively, to ground.

During writing, the appropriate global word lines 302, 314, and 324 are used for writing. Either global word line 314 or global word line 324 may be used as a return, depending upon the cells in which data are being stored. In particular, if cells corresponding to a particular word line 302 or 314 are written, an adjacent word line 314 or 324, respectively, is used as a global word line return. For example, when writing to cells C31 and C32, the global word line 302 is coupled with a word line current source (not shown). The adjacent global word line 314 is coupled with a word line current sink. An enable voltage is provided to read word line 336. Consequently, the transistor T3a is enabled and current flows through the word line segment 178 (as well as word line segment 180). In addition, an enable voltage is provided to partition line 344. Consequently, transistors Tb1 and Tb2 are turned on. Bit line current sources and sinks are connected to the appropriate bit lines 304 and 308 and to the appropriate bit line returns 306 and 310. Consequently, the cells C31 and C32 can be written.

Thus, the MRAM 300 enjoys essentially the same benefits as the MRAM 200 depicted in Figure 6. However, a more efficient architecture can be achieved while simplifying processing and reducing the cost of the MRAM 300. Data can be read and written in parallel to cells on the same word line segment and/or bit line segment. Furthermore, some word line returns have been eliminated by merging the return function with adjacent word lines. Consequently, the MRAM 200 is even simpler to fabricate.

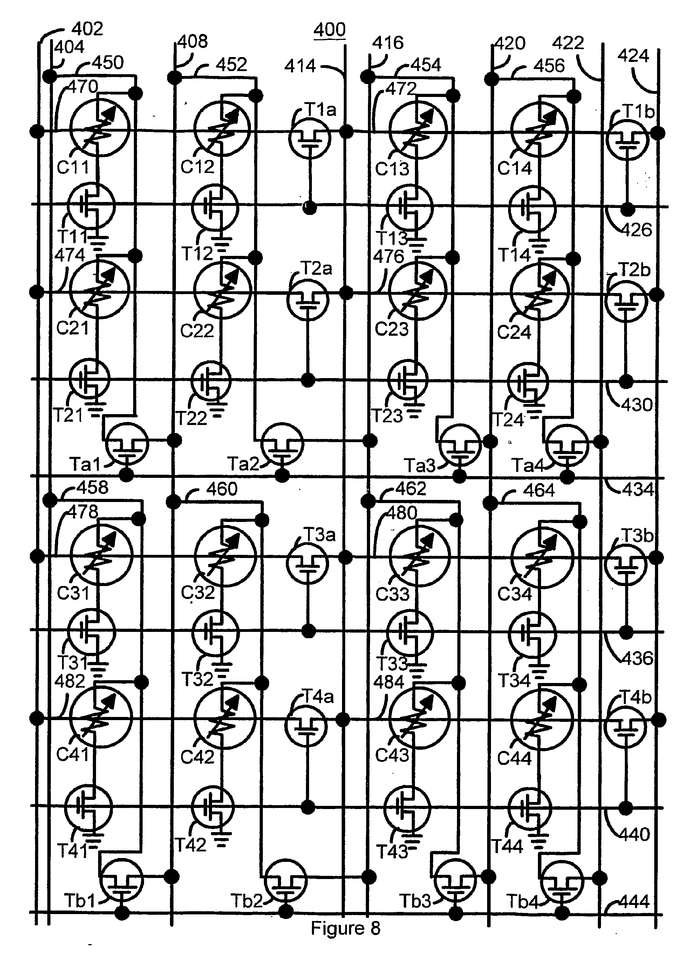

Figure 8 is a schematic diagram illustrating a fourth embodiment of a portion of an MRAM 400 in accordance with the present invention. Elements of the MRAM 400 are analogous to those in the MRAM 300. Consequently, such components are labeled similarly. For example, the MRAM 400 includes cells C11, C12, C13, C14, C21, C22, C23, C24, C31, C32, C33, C34, C41, C42, C43, and C44. Similarly, the MRAM 400 includes global bit lines 404, 408, 416, and 420 (analogous to global bit lines 304, 308, 316, and 320 Figure 7). However, the MRAM 400 has combined at least a portion of the global bit return lines and global bit lines of Figure 7. In particular, the bit line returns 306, 310 and 318 have been eliminated. Referring to Figures 6 and 7, in the MRAM 400, the global bit lines 404, 408 and 416 use the global bit lines 408, 416, and 420, respectively, as return lines. Thus, a global bit line 408, 416, or 420 may function as a return line for an adjacent global bit line 402, 408, and 416, respectively.

The MRAM 400 is read in the same way as the MRAM 100, using the read word line 426, 430, 436, or 440 to enable the appropriate transistors and coupled the appropriate cells to ground. For example, in reading cells C11 and C12, the read word line 426 enables transistors T11 and T12 (as well as transistor T1a) to couple the cells C11 and C12 to ground. A current passed through the global bit lines 404 and 408 is thus transmitted through bit line segments 450 and 452 and through the cells C33 and C34, respectively, to ground.

During writing, the desired currents are provided through the appropriate bit line segments and word line segments in the desired polarity. In addition, adjacent global bit lines and adjacent global word lines may be used as return lines. As a result, two adjacent bits are not written simultaneously. For example, suppose data is to be written to cells C31 and C32. The global word line 402 is coupled with a word line current source (not shown), while the adjacent global word line 408 is coupled to a word line current sink (not shown). An enable voltage is provided via read word line 436. Consequently, transistor T3a is turned on. Thus, the word line current flows through the segment 478 and cells C31 and C32. The appropriate bit line current is provided by connecting bit line 404 to a bit line current source (not shown) and the bit line 408 to a bit line current sink (not shown), or vice versa. In addition, an enable voltage is provided over the partition line 444, which turns on transistors Tb1 (as well as transistors Tb2, Tb3, and Tb4). Thus, current travels through the bit line segment 458 and the cell C31 can be written. However, because the bit line 408 is used as a return, the cell C32 is not written to at the same time as the cell C31. In order to write to the cell C32, the appropriate bit line current is provided by connecting bit line 408 to a bit line current source (not shown) and the bit line 416 to a bit line current sink (not shown), or vice versa. The enable voltage is also provided over the partition line 444, which turns on transistor Tb2. Thus, current flows through bit line segment 460 and the cell C32 can be written.

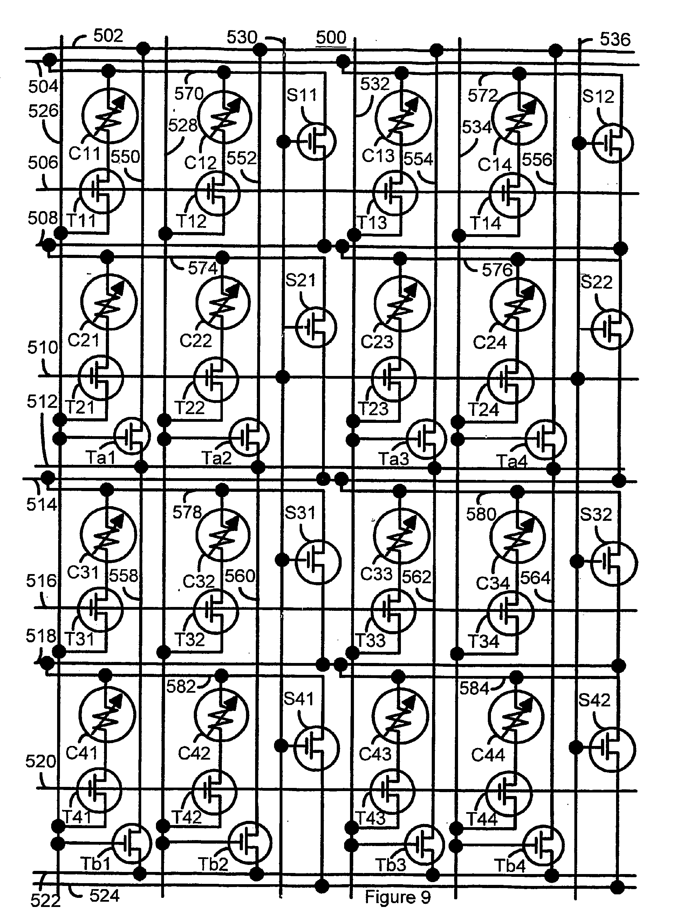

Figure 9 is a schematic diagram illustrating a fifth embodiment of a portion of an MRAM 500 in accordance with the present invention. The MRAM 500 includes cells C11, C12, C13, C14, C21, C22, C23, C24, C31, C32, C33, C34, C41, C42, C43, and C44. The cells C11, C12, C13, C14, C21, C22, C23, C24, C31, C32, C33, C34, C41, C42, C43, and C44 preferably include MTJ stacks (not shown) such as the MTJ stacks 90 and 90' depicted in Figures 4A and 4B. Thus, the MTJ stacks in the MRAM 500 preferably include magnetic layers 92 (not explicitly shown in Figure 9) and 94 (not explicitly shown in Figure 9) separated by an insulating barrier layer 93 (not explicitly shown in Figure 9). The free layer 94 is separated from the corresponding magnetic bit line segment by the nonmagnetic conductive capping layer 95 (not explicitly shown in Figure 9). Also in a preferred embodiment, the easy axis of each of the free layers 94 of the MTJ stacks 90 are preferably aligned substantially parallel with the corresponding magnetic write line segment, as depicted in Figure 4A. Because of the small spacing between the free layer 94 and the corresponding bit line, the magnetization of the free layer is strongly coupled magnetostatically to the corresponding magnetic bit line segment. During writing, a flux closure is formed between the magnetic vectors of the free layer 94 and that of the corresponding magnetic bit line segment. A small current in the corresponding magnetic bit line segment can be used to disturb all MTJ elements in contact with the magnetic write lines. Thus the magnetic write line 82 depicted in Figure 4A is labeled word line in a conventional sense, that all MTJ elements associated with the word line can be addressed simultaneously. Referring back to Figure 9, the MRAM 500 also includes transistors T11, T12, T13, T14, T21, T22, T23, T24, T31, T32, T33, T34, T41, T42, T43, and T44; as well as selection devices Ta1, Ta2, Ta3, Ta4, Tb1, Tb2, Tb3, Tb4, S11, S12, S21, S22, S31, S32, S41, and S42 that are preferably transistors. In an alternate embodiment, the selection devices could be diodes.

The MRAM 500 includes segmented magnetic bit lines and/or segmented magnetic word lines. In addition, the MRAM 500 includes magnetic bit line segments 550, 552, 554, 556, 558, 560, 562, and 564 and magnetic word line segments 570, 572, 574, 576, 578, 580, 582, and 584. However, the global word lines 504, 508, 514, and 518; the global read word lines 506, 510, 516, and 522; the global read bit lines 526, 528, 532, and 534; the global bit lines 502, 512, and 522; and the bit partition lines 530, and 536 are preferably nonmagnetic, high conductivity material(s) such as copper.

The word line segments 570, 572, 574, 576, 578, 580, 582, and 584 preferably include a conductive soft magnetic material. In one embodiment, one or more of the word line segments 570, 572, 574, 576, 578, 580, 582, and 584 are completely composed of a conductive soft magnetic material(s). In an alternate embodiment, one or more of the word line segments 570, 572, 574, 576, 578, 580, 582, and 584 include soft magnetic material(s) formed on a high conductivity material, such as copper. Thus, the word line segments 570, 572, 574, 576, 578, 580, 582, and 584 may be analogous to the bit lines 82 and 82' of Figures 4A and 4B.

In order to write to the MTJ stacks 90 or 90' in the cells C11, C12, C13, C14, C21, C22, C23, C24, C31, C32, C33, C34, C41, C42, C43, and C44, the desired currents are provided through the appropriate bit line segments 550, 552, 554, 556, 558, 560, 562, and 564 and the appropriate word line segments 570, 572, 574, 576, 578, 580, 582, and 584. For example, writing to cells C33 and C34 is described. The global word line 514 and global word line 518 are coupled with a word line current source (not shown) and word line current sink, respectively. An enable voltage is provided to the bit partition line 536, which enables the transistor S32 (as well as transistors S 12, S22, and S42). As a result, the word line current flows through the magnetic word lines segment 580 and can be used to write to the cells C33 and C34.

The bit line current and polarity determines the logical state of the cells C33 and C34. To provide the bit line current, the global bit line 512 is coupled with a bit line current source (not shown) while the global bit line 522 is coupled with a bit line current sink (not shown), or vice versa. To allow the flow of current through the appropriate magnetic bit line segments 562 and 564, an enable voltage is provided via read bit line 532 and 534, which turns on transistors Ta3 and Tb3. Consequently, the currents flow through the magnetic bit line segment 562 and the magnetic word line segment 580, allowing the cell C33 to be written. The cell C34 is written in a similar manner. However, instead of utilizing read bit line 532, read bit line 534 is used to turn transistors Ta4 and Tb4. However, because cells C33 and C34 share global bit lines 512 and 522 for writing, these cells are written at different times to ensure that the desired bit line current is used for each cell. In general, where there are many bits associated with one magnetic word line segment 570, 572, 574, 576, 578, 580, 582, or 584, at least two steps are used in writing a word. First writing all the bits with the state "1", and then all the bits with the state "0". The driver circuit would be either a voltage source or a programmable current source.

To read the data stored in the cells C33 and C34, the global word line 514 is coupled to ground and an enable signal is provided to the read word line 516. Consequently, the cells C33 and C34 are coupled to read bit lines 532 and 534, respectively. A read current is provided over the read bit lines 532 and 534. The voltage of these read bit liens 532 and 534 can be measured to determine the data stored in the cells C33 and C34.

Thus, the MRAM 500 shares many of the benefits of the MRAMs 100, 200, 300, and 400. Using the MRAM 500, therefore, thinner bit line segments 550, 552, 554, 556, 558, 560, 562, and 564 and thinner word line segments 570, 572, 574, 576, 578, 580, 582, and 584 can be provided. Moreover, the global bit lines 502, 512, and 522; the global word lines 504, 508, 514, 518, and 524; as well as other global lines 506, 516, 520, 526, 528, 530, 532, 534, and 536 can be made thicker, as well as using higher conductivity materials. Consequently, the benefits of thinner word and bit lines can be achieved without sacrificing performance due to high resistivity of thinner lines. In addition, in the architecture depicted in Figure 9, the global word lines 504, 508, 514, 518, and 524 and the read word lines 506, 510, 516, and 520 are parallel to the global bit lines 502, 512, and 522. Consequently, these structures 502, 504, 506, 508, 510, 512, 514, 516, 518, 520, 522, and 524 may be fabricated on the same layer, further reducing the cost of fabricating the MRAM 500. In addition, the bit line segments 550, 552, 554, 556, 558, 560, 562, and 564 and word line segments 570, 572, 574, 576, 578, 580, 582, and 584 are made in part or completely of soft magnetic materials. As a result, an even more efficient writing architecture can be achieved. As a result, performance of the MRAM 100 can be enhanced while simplifying processing and reducing cost.

A method and system has been disclosed for providing a magnetic random access memory having improved writing margin and more efficient reading. Although the present invention has been described in accordance with the embodiments shown, one of ordinary skill in the art will readily recognize that there could be variations to the embodiments and those variations would be within the scope of the present invention. Accordingly, many modifications may be made by one of ordinary skill in the art without departing from the scope of the appended claims.

## Claims

1. A magnetic random access memory array (100) comprising:
a plurality of magnetic storage cells;
a plurality of global word lines (102, 114);
a plurality of word line segments, each of the plurality of word line segments being coupled with at least one of the plurality of global word lines such that the plurality of word line segments is selectable, each of the plurality of word line segments being coupled to a first portion of the plurality of magnetic storage cells;
a plurality of global bit lines (104, 108, 116, 120);
a plurality of bit line segments, each of the plurality of bit line segments being coupled with at least one of the plurality of global bit lines such the plurality of bit line segments is selectable, each of the plurality of bit line segments being magnetostatically coupled to a second portion of the plurality of magnetic storage cells to write to the second portion of the plurality of magnetic storage cells; and
a plurality of selection devices, the plurality of bit line segments and the plurality of word line segments being coupled with and selectable using the plurality of selection devices, **characterised in that**:
the magnetic random access memory array (100) further comprises at least one global word line return (112, 124) coupled with at least one of the plurality of global word lines (102, 114) through at least one of the plurality of selection devices; and
the magnetic random access memory array (100) further comprises at least one global bit line return (106, 110, 118, 122) coupled with at least one of the plurality of global bit lines (104, 108, 116, 120) through at least one of the plurality of selection devices.

2. The magnetic random access memory array (100) of claim 1, wherein the at least one global word line return (112, 124) further includes a plurality of global word line returns (112, 124).

3. The magnetic random access memory array (100) of claim 2, wherein each of the plurality of global word line returns (112, 124) corresponds to one of the plurality of global word lines (102, 114).

4. The magnetic random access memory array (100) of either claim 2 or claim 3,
wherein at least a portion of the plurality of word line segments is magnetic.

5. The magnetic random access memory array (100) of any one of claims 2 to 4,
wherein the plurality of global word lines (102, 104) have a lower resistance than the plurality of word line segments.

6. The magnetic random access memory array (100) of claim 5, wherein each of the plurality of global word line segments has a thickness and a width, the thickness being less than the width.

7. The magnetic random access memory array (100) of claim 6, wherein the thickness of each of the global word line segments is less than or equal to one fourth of the width.

8. The magnetic random access memory array (100) of claim 1, wherein the at least one global bit line return (106, 110, 118, 122) further includes a plurality of global bit line returns (106, 110, 118, 122).

9. The magnetic random access memory array (100) of claim 8, wherein each of the plurality of global bit line returns (106, 110, 118, 122) corresponds to one of the plurality of global bit lines (104, 108, 116, 120).

10. The magnetic random access memory array (100) of either claim 8 or claim 9,
wherein at least a portion of the plurality of bit line segments is magnetic.

11. The magnetic random access memory array (100) of any one of claims 8 to 10,
wherein the plurality of global bit lines have a lower resistance than the plurality of bit line segments.

12. The magnetic random access memory array of any one of claims 1 to 11,
wherein the plurality of global bit lines (104, 108, 116, 120) is substantially parallel to the plurality of global word lines (102, 114).

13. The magnetic random access memory array (100) of any one of claims 1 to 11,
wherein the plurality of global bit lines (104, 108, 116, 120) and the plurality of global word lines (102, 114) are both manufactured on a particular metal layer.

14. The magnetic random access memory array (100) of any one of claims 1 to 11,
wherein the plurality of selection devices include a plurality of transistors or a plurality of diodes.

15. The magnetic random access memory array (100) of any one of claims 1 to 14,
wherein each of the plurality of magnetic storage cells includes a magnetic tunneling junction including a free layer, a barrier layer, and a pinned layer, the word line segment(s) being magnetically coupled with the free layer in each of the first portion of the magnetic storage cells.

16. A method for utilizing a magnetic random access memory array (100) having a plurality of magnetic storage cells and a plurality of global word lines (102, 114), the method comprising:
(a) in a write mode, driving a word line current through at least one of the plurality of global word lines (102, 114);
(b) in the write mode, driving at least a portion of the word line current from the at least one of the plurality of global word lines (102, 114) through at least one of a plurality of word line segments, each of the plurality of word line segments being coupled with a portion of the plurality of global word lines (102, 114) such that the plurality of word line segments is separately selectable, each of the plurality of word line segments being coupled to a first portion of the plurality of magnetic storage cells;
(c) in the write mode, driving a bit line current through at least one of a plurality of global bit lines (104, 108, 116, 120); and
(d) in the write mode, providing at least a portion of the bit line current through a portion of a plurality of bit line segments, each of the plurality of bit line segments being coupled with at least one of the plurality of global bit lines (104, 108, 116, 120) such that the plurality of bit line segments is selectable, each of the plurality of segments being magnetostatically coupled to a second portion of the plurality of magnetic storage cells to write to the second portion of the plurality of magnetic storage cells; wherein the plurality of bit line segments and the plurality of word line segments are coupled with and selectable using the plurality of selection devices, **characterised in that** either:
the global word line driving step (a) further comprises (a1) utilizing at least one global word line return (112, 114) coupled with at least one of the plurality of global word lines (102, 114) through at least one selection device to return the word line current; or
the global bit line driving step (c) further comprises (c1) utilizing at least one global bit line return (106, 110, 118, 122) coupled with at least one of the plurality of global bit lines (104, 108, 116, 120) through at least one selection device to return the bit line current.

17. The method of claim 16 further comprising the steps of:
(e) in a read mode, grounding a global word line (102, 114), the read mode for reading a portion of the plurality of magnetic storage device;
(f) in the read mode, providing a read current in a portion of the plurality of global bit lines (104, 108, 116, 120);
(g) in the read mode, providing the read current in a portion of the plurality of bit line segments; and
(h) in the read mode, reading a voltage across a portion of the plurality magnetic storage cells.

## Patentansprüche

1. Magnetische Direktzugriffspeicher-Matrix (MRAM-Array) (100), der Folgendes umfasst:
eine Mehrzahl magnetischer Speicherzellen;
eine Mehrzahl globaler Wortleitungen (102, 114);
eine Mehrzahl von Wortleitungssegmenten, wobei jedes der Wortleitungssegmente mit mindestens einer der Mehrzahl globaler Wortleitungen verbunden ist, so dass die Mehrzahl von Wortleitungssegmenten auswählbar ist, wobei jedes der Mehrzahl von Wortleitungssegmenten mit einem ersten Teil der Mehrzahl magnetischer Speicherzellen verbunden ist;
eine Mehrzahl globaler Bitleitungen (104, 108, 116, 120);
eine Mehrzahl von Bitleitungssegmenten, wobei jedes der Mehrzahl von Bitleitungssegmenten mit mindestens einer der Mehrzahl globaler Bitleitungen verbunden ist, so dass die Mehrzahl von Bitleitungssegmenten auswählbar ist, wobei jedes der Mehrzahl von Bitleitungssegmenten mit einem zweiten Teil der Mehrzahl magnetischer Speicherzellen verbunden ist, um in den zweiten Teil der Mehrzahl magnetischer Speicherzellen zu schreiben; und
eine Mehrzahl von Auswahlvorrichtungen, wobei die Mehrzahl von Bitleitungssegmenten und die Mehrzahl von Wortleitungssegmenten mit der Mehrzahl von Auswahlvorrichtungen verbunden sind und durch deren Verwendung auswählbar sind, **dadurch gekennzeichnet, dass**:
die magnetische Direktzugriffsspeicher-Matrix (MRAM-Array) (100) ferner mindestens eine globale Wortleitungsrückführung (112, 124) umfasst, die über mindestens eine der Mehrzahl von Auswahlvorrichtungen mit mindestens einer der Mehrzahl globaler Wortleitungen (102, 114) verbunden ist; und
das magnetische Direktzugriffsspeicher-Matrix (MRAM-Array) (100) ferner mindestens eine globale Bitleitungsrückführung (106, 110, 118, 122) umfasst, die über mindestens eine der Mehrzahl von Auswahlvorrichtungen mit mindestens einer der Mehrzahl globaler Bitleitungen (104, 108, 116, 120) verbunden ist.

2. Magnetischer Direktzugriffsspeicher-Matrix (MRAM-Array) (100) gemäß Anspruch 1, wobei die mindestens eine globale Wortleitungsrückführung (112, 124) ferner eine Mehrzahl globaler Wortleitungsrückführungen (112, 124) umfasst.

3. Magnetischer Direktzugriffsspeicher-Matrix (MRAM-Array) (100) gemäß Anspruch 2, wobei jede der Mehrzahl globaler Wortleitungsrückführungen (112, 124) einer der Mehrzahl globaler Wortleitungen (102, 114) zugeordnet ist.

4. Magnetischer Direktzugriffsspeicher-Matrix (MRAM-Array) (100) gemäß Anspruch 2 oder 3, wobei mindestens ein Teil der Mehrzahl von Wortleitungssegmenten magnetisch ist.

5. Magnetischer Direktzugriffsspeicher-Matrix (MRAM-Array) (100) gemäß einem der Ansprüche 2 bis 4, wobei die Mehrzahl globaler Wortleitungen (102, 104) einen geringeren Widerstand haben als die Mehrzahl von Wortleitungssegmenten.

6. Magnetischer Direktzugriffsspeicher-Matrix (MRAM-Array) (100) gemäß Anspruch 5, wobei jedes der Mehrzahl globaler Wortleitungssegmente eine Dicke und eine Breite aufweist, wobei die Dicke geringer ist als die Breite.

7. Magnetischer Direktzugriffsspeicher-Matrix (MRAM-Array) (100) gemäß Anspruch 6, wobei die Dicke jedes der globalen Wortleitungssegmente kleiner oder gleich einem Viertel der Breite ist.

8. Magnetischer Direktzugriffsspeicher-Matrix (MRAM-Array) (100) gemäß Anspruch 1, wobei die mindestens eine globale Bitleitungsrückführung (106, 110, 118, 122) ferner eine Mehrzahl globaler Bitleitungsrückführungen (106, 110, 118, 122) umfasst.

9. Magnetischer Direktzugriffsspeicher-Matrix (MRAM-Array) (100) gemäß Anspruch 8, wobei jede der Mehrzahl globaler Bitleitungsrückführungen (106, 110, 118, 122) einer der Mehrzahl globaler Bitleitungen (104, 108, 116, 120) zugeordnet ist.

10. Magnetischer Direktzugriffsspeicher-Matrix (MRAM-Array) (100) gemäß Anspruch 8 oder Anspruch 9, wobei mindestens ein Teil der Mehrzahl von Bitleitungssegmenten magnetisch ist.

11. Magnetischer Direktzugriffsspeicher-Matrix (MRAM-Array) (100) gemäß einem der Ansprüche 8 bis 10, wobei die Mehrzahl globaler Bitleitungen einen geringeren Widerstand als die Mehrzahl von Bitleitungssegmenten hat.

12. Magnetischer Direktzugriffsspeicher-Matrix (MRAM-Array) (100) gemäß einem der Ansprüche 1 bis 11, wobei die Mehrzahl globaler Bitleitungen (104, 108, 116, 120) im wesentlichen parallel zu der Mehrzahl globaler Wortleitungen (102, 114) ist.

13. Magnetischer Direktzugriffsspeicher-Matrix (MRAM-Array) (100) gemäß einem der Ansprüche 1 bis 11, wobei die Mehrzahl globaler Bitleitungen (104, 108, 116, 120) und die Mehrzahl globaler Wortleitungen (102, 114) auf einer besonderen Metallschicht gefertigt sind.

14. Magnetischer Direktzugriffsspeicher-Matrix (MRAM-Array) (100) gemäß einem der Ansprüche 1 bis 11, wobei die Mehrzahl von Auswahlvorrichtungen eine Mehrzahl von Transistoren oder eine Mehrzahl von Dioden umfasst.

15. Magnetischer Direktzugriffsspeicher-Matrix (MRAM-Array) (100) gemäß einem der Ansprüche 1 bis 14, wobei jede der Mehrzahl von Speicherzellen einen magnetischen Durchtunnelungsanschluss mit einer freien Schicht, einer Sperrschicht und einer festen Schicht (Pinned-Schicht) umfasst, wobei die Wortleitungssegmente in jedem ersten Teil der magnetischen Speicherzellen mit der freien Schicht magnetisch gekoppelt sind.

16. Verfahren zur Nutzung eines magnetischen Direktzugriffsspeicher-Matrix (MRAM-Array) (100) mit einer Mehrzahl magnetischer Speicherzellen und einer Mehrzahl globaler Wortleitungen (102, 114), wobei das Verfahren umfasst:
(a) im Schreibmodus das Durchleiten eines Wortleitungsstroms durch mindestens eine der Mehrzahl globaler Wortleitungen (102, 114);
(b) im Schreibmodus das Durchleiten zumindest eines Teils des Wortleitungsstroms von der mindestens einen der Mehrzahl globaler Wortleitungen (102, 114) durch mindestens eines einer Mehrzahl von Wortleitungssegmenten, wobei jedes der Mehrzahl von Wortleitungssegmenten mit einem Teil der Mehrzahl globaler Wortleitungen (102, 114) gekoppelt ist, so dass die Mehrzahl von Wortleitungssegmenten getrennt wählbar ist, wobei jedes der Mehrzahl von Wortleitungssegmenten mit einem ersten Teil der Mehrzahl magnetischer Speicherzellen verbunden ist;
(c) im Schreibmodus das Durchleiten eines Bitleitungsstroms durch mindestens eine einer Mehrzahl globaler Bitleitungen (104, 108, 116, 120); und
(d) im Schreibmodus die Bereitstellung zumindest eines Teils des Bitleitungsstroms durch einen Teil einer Mehrzahl von Bitleitungssegmenten, wobei jedes der Mehrzahl von Bitleitungssegmenten mit mindestens einer der Mehrzahl globaler Bitleitungen (104, 108, 116, 120) verbunden ist, so dass die Mehrzahl von Bitleitungssegmenten auswählbar ist, wobei jedes der Mehrzahl von Segmenten magnetostatisch mit einem zweiten Teil der Mehrzahl magnetischer Speicherzellen verbunden ist, um in den zweiten Teil der Mehrzahl magnetischer Speicherzellen zu schreiben, wobei die Mehrzahl von Bitleitungssegmenten und die Mehrzahl von Wortleitungssegmenten mit der Mehrzahl von Auswahlvorrichtungen gekoppelt und unter deren Verwendung auswählbar sind, **dadurch gekennzeichnet, dass** entweder
der Schritt (a) der Ansteuerung der globalen Wortleitung ferner die Nutzung von mindestens einer globalen Wortleitungsrückführung (112, 114), die mit mindestens einer der Mehrzahl globaler Wortleitungen (102, 114) verbunden ist, durch mindestens eine Auswahlvorrichtung umfasst (a1), um den Wortleitungsstrom zurück zu führen; oder
der Schritt (c) der Ansteuerung der globalen Bitleitung ferner die Nutzung von mindestens einer globalen Bitleitungsrückführung (106, 110, 118, 122), die mit mindestens einer der Mehrzahl globaler Bitleitungen (104, 108, 116, 120) verbunden ist, durch mindestens eine Auswahlvorrichtung umfasst (c1), um den Bitleitungsstrom zurück zu führen;

17. Verfahren gemäß Anspruch 16, das ferner folgende Schritte umfasst:
(e) in einem Lesemodus die Erdung einer globalen Wortleitung (102, 114), wobei der Lesemodus dem Lesen eines Teils der Mehrzahl magnetischer Speichervorrichtungen dient;
(f) im Lesemodus die Bereitstellung eines Lesestroms in einem Teil der Mehrzahl globaler Bitleitungen (104, 108, 116, 120);
(g) im Lesemodus Bereitstellung des Lesestroms in einem Teil der Mehrzahl von Bitleitungssegmenten; und
(h) im Lesemodus das Einlesen einer Spannung über einen Teil der Mehrzahl magnetischer Speicherzellen.

## Revendications

1. Batterie de mémoires vives magnétiques (100) comprenant :
une pluralité de cellules magnétiques de mémorisation,
une pluralité de lignes de mots globales (102, 114),
une pluralité de segments de lignes de mots, chaque segment parmi la pluralité de segments de lignes de mots étant couplé à au moins une ligne parmi la pluralité de lignes de mots globales de sorte que la pluralité de segments de lignes de mots puisse faire l'objet d'une sélection, chaque segment parmi la pluralité de segments de lignes de mots étant couplé à une première partie de la pluralité de cellules magnétiques de mémorisation,
une pluralité de lignes de bits globales (104,108,116,120),
une pluralité de segments de lignes de bits, chaque segment parmi la pluralité de segments de lignes de bits étant couplé à au moins une ligne parmi la pluralité de lignes de bits globales de sorte que la pluralité de segments de lignes de bits puissent faire l'objet d'une sélection, chaque segment de la pluralité de segments de lignes de bits étant couplé de manière magnétostatique à une deuxième partie de la pluralité de cellules magnétiques de mémorisation en vue d'une écriture dans la deuxième partie de la pluralité de cellules magnétiques de mémorisation, et
une pluralité de dispositifs de sélection, la pluralité de segments de lignes de bits et la pluralité de segments de lignes de mots étant couplés et pouvant faire l'objet d'une sélection en utilisant la pluralité de dispositifs de sélection, **caractérisée en ce que** :
la batterie de mémoires vives magnétiques (100) comprend en outre au moins un retour de lignes de mots globales (112,124) couplé à au moins une ligne parmi la pluralité de lignes de mots globales (102,114) par le biais d'au moins un dispositif parmi la pluralité de dispositifs de sélection, et
la batterie de mémoires vives magnétiques (100) comprend en outre au moins un retour de lignes de bits globales (106,110,118,122) couplé à au moins une ligne parmi la pluralité de lignes de bits globales (104,108,116,120) par le biais d'au moins un dispositif parmi la pluralité de dispositifs de sélection.

2. Batterie de mémoires vives magnétiques (100) selon la revendication 1, dans laquelle le au moins un retour de lignes de mots globales (112,124) comprend en outre une pluralité de retours de lignes de mots globales (112,124).

3. Batterie de mémoires vives magnétiques (100) selon la revendication 2, dans laquelle chaque retour parmi la pluralité de retours de lignes de mots globales (112,124) correspond à une ligne parmi la pluralité de lignes de mots globales (102,114).

4. Batterie de mémoires vives magnétiques (100) selon la revendication 2 ou la revendication 3, dans laquelle au moins une partie de la pluralité de segments de lignes de mots est magnétique.

5. Batterie de mémoires vives magnétiques (100) selon l'une quelconque des revendications 2 à 4, dans laquelle la pluralité de lignes de mots globales (102,104) présentent une résistance inférieure à celle de la pluralité de segments de lignes de mots.

6. Batterie de mémoires vives magnétiques (100) selon la revendication 5, dans laquelle chaque segment parmi la pluralité de segments de lignes de mots globales a une épaisseur et une largeur, l'épaisseur étant inférieure à la largeur.

7. Batterie de mémoires vives magnétiques (100) selon la revendication 6, dans laquelle l'épaisseur de chaque segment parmi les segments de lignes de mots globales est inférieure ou égale à un quart de la largeur.

8. Batterie de mémoires vives magnétiques (100) selon la revendication 1, dans laquelle le au moins un retour de lignes de bits globales (106,110,118,122) comprend en outre une pluralité de retours de lignes de bits globales (106,110,118,122).

9. Batterie de mémoires vives magnétiques (100) selon la revendication 8, dans laquelle chaque retour parmi la pluralité de retours de lignes de bits globales (106,110,118,122) correspond à une ligne parmi la pluralité de lignes de bits globales (104,108,116,120).

10. Batterie de mémoires vives magnétiques (100) selon la revendication 8 ou la revendication 9, dans laquelle au moins une partie de la pluralité de segments de lignes de bits est magnétique.

11. Batterie de mémoires vives magnétiques (100) selon l'une quelconque des revendications 8 à 10, dans laquelle la pluralité de lignes de bits globales a une résistance inférieure à celle de la pluralité de segments de lignes de bits.

12. Batterie de mémoires vives magnétiques selon l'une quelconque des revendications 1 à 11, dans laquelle la pluralité de lignes de bits globales (104,108,116,120) est pratiquement parallèle à la pluralité de lignes de mots globales (102,114).

13. Batterie de mémoires vives magnétiques (100) selon l'une quelconque des revendications 1 à 11, dans laquelle la pluralité de lignes de bits globales (104,108,116,120) et la pluralité de lignes de mots globales (102,114) sont toutes deux réalisées sur une couche de métal particulière.

14. Batterie de mémoires vives magnétiques (100) selon l'une quelconque des revendications 1 à 11, dans laquelle la pluralité de dispositifs de sélection inclut une pluralité de transistors ou une pluralité de diodes.

15. Batterie de mémoires vives magnétiques (100) selon l'une quelconque des revendications 1 à 14, dans laquelle chaque cellule parmi la pluralité de cellules magnétiques de mémorisation inclut une jonction magnétique à effet tunnel comprenant une couche libre, une couche barrière et une couche ancrée, le ou les segments de lignes de mots étant magnétiquement couplés à la couche libre dans chaque cellule de la première partie des cellules magnétiques de mémorisation.

16. Procédé d'utilisation d'une batterie de mémoires vives magnétiques (100) comportant une pluralité de cellules magnétiques de mémorisation et une pluralité de lignes de mots globales (102,114), le procédé comprenant les étapes consistant à :
(a) dans un mode d'écriture, faire passer un courant de ligne de mots à travers au moins une ligne parmi la pluralité de lignes de mots globales (102,114),
(b) dans le mode d'écriture, faire passer au moins une partie du courant de ligne de mots depuis la au moins une ligne parmi la pluralité de lignes de mots globales (102,114) à travers au moins un segment parmi une pluralité de segments de lignes de mots, chaque segment de la pluralité de segments de lignes de mots étant couplé à une partie de la pluralité de lignes de mots globales (102,114), de sorte que la pluralité de segments de lignes de mots puissent séparément faire l'objet d'une sélection, chaque segment parmi la pluralité de segments de lignes de mots étant couplé à une première partie de la pluralité de cellules magnétiques de mémorisation,
(c) dans le mode d'écriture, faire passer un courant de ligne de bits à travers au moins une ligne parmi une pluralité de lignes de bits globales (104,108,116,120) et
(d) dans le mode d'écriture, fournir au moins une partie du courant de ligne de bits à travers une partie d'une pluralité de segments de lignes de bits, chaque segment parmi la pluralité de segments de lignes de bits étant couplé à au moins une ligne parmi la pluralité de lignes de bits globales (104,108,116,120) de sorte que la pluralité de segments de lignes de bits puissent faire l'objet d'une sélection, chaque segment parmi la pluralité de segments étant couplé de manière magnétostatique à une deuxième partie de la pluralité de cellules magnétiques de mémorisation en vue d'une écriture dans la deuxième partie de la pluralité de cellules magnétiques de mémorisation, où la pluralité de segments de lignes de bits et la pluralité de segments de lignes de mots sont couplés à la pluralité de dispositifs de sélection et peuvent faire l'objet d'une sélection en utilisant la pluralité de dispositifs de sélection, **caractérisé en ce que** :
soit l'étape consistant à faire passer un courant à travers une ligne de bits globale (a) comprend en outre (a1) l'utilisation d'au moins un retour de ligne de mots globale (112,114) couplé à au moins une ligne parmi la pluralité de lignes de mots globales (102,114) par le biais d'au moins un dispositif de sélection pour renvoyer le courant de ligne de mots,
soit l'étape consistant à faire passer un courant à travers une ligne de bits globale (c) comprend en outre (c1) l'utilisation d'au moins un retour de ligne de bits globale (106,110,118,122) couplé à au moins une ligne parmi la pluralité de lignes de bits globales (104,108,116,120) par le biais d'au moins un dispositif de sélection pour renvoyer le courant de ligne de bits.

17. Procédé selon la revendication 16 comprenant en outre les étapes consistant à :
(e) dans un mode de lecture, mettre à la masse une ligne de mots globale (102,114), le mode de lecture étant destiné à lire une partie de la pluralité de cellules magnétiques de mémorisation,
(f) dans le mode de lecture, fournir un courant de lecture dans une partie de la pluralité de lignes de bits globales (104,108,116,120),
(g) dans le mode de lecture, fournir le courant de lecture dans une partie de la pluralité de segments de lignes de bits, et
(h) dans le mode de lecture, lire une tension aux bornes d'une partie de la pluralité de cellules magnétiques de mémorisation.
